Europäisches Patentamt

European Patent Office

Office européen des brevets

(11) Veröffentlichungsnummer: **0 240 885**
**A2**

(12) **EUROPÄISCHE PATENTANMELDUNG**

(21) Anmeldenummer: **87104647.0**

(22) Anmeldetag: **28.03.87**

(51) Int. Cl.⁴: **H05K 7/18 , H05K 9/00**

(30) Priorität: **08.04.86 DE 3611693**

(43) Veröffentlichungstag der Anmeldung:
**14.10.87 Patentblatt 87/42**

(84) Benannte Vertragsstaaten:
**AT BE CH ES FR GB GR IT LI LU NL SE**

(71) Anmelder: **Rittal-Werk Rudolf Loh GmbH & Co. KG**
**Auf dem Stützelberg**
**D-6348 Herborn(DE)**

(72) Erfinder: **Koch, Hans-Georg**
**Sonnenstrasse 28**
**D-6344 Dietzhölztal 1(DE)**

(74) Vertreter: **Vogel, Georg**
**Hermann-Essig-Strasse 35**
**D-7141 Schwieberdingen(DE)**

(54) **Schaltschrank mit einem Rahmengestell.**

(57) Die Erfindung betrifft einen Schaltschrank mit einem Rahmengestell, dessen Vorder-und Rückseite mittels zweier am Rahmengestell angelenkter Schranktüren oder mittels einer am Rahmengestell angelenkten Schranktür und einer lösbar am Rahmengestell angebrachten Rückwand verschließbar sind und dessen übrige Seiten mittels lösbar am Rahmengestell anbringbarer Abdeckplatten abdeckbar sind. Eine HF-Abschirmung wird dadurch erreicht, daß zur HF-Abschirmung in das Rahmengestell ein zwei Seitenwände, eine Deckwand und eine Bodenwand aufweisender, kastenförmiger und HF-dichter Einsatz eingebracht und so mit dem Rahmengestell verbunden ist, daß die Vorder-und Rückseite des Rahmengestelles mit den Öffnungen des Einsatzes zusammenfallen, daß der Einsatz im Bereich beider Öffnungen auf allen Seiten seiner Innenwandung federnde Kontaktstreifen trägt, daß die Schranktüren und die Rückwand auf ihren Innenseiten mit Abschirmplatten versehen sind, die einen auf die Öffnungen des Einsatzes abgestimmten umlaufenden Rand aufweisen, und daß die Ränder der Abschirmplatten auf allen Außenseiten federnde Kontaktstreifen tragen, die in der Schließstellung von Schranktür und Rückwand mit den Kontaktstreifen des Einsatzes zur Deckung kommen und diesen HF-dicht mit den Abschirmplatten von Schranktür und Rückwand verbinden.

FIG.1

## Schaltschrank mit einem Rahmengestell

Die Erfindung betrifft einen Schaltschrank mit einem Rahmengestell, dessen Vorder-und Rückseite mittels zweier am Rahmengestell angelenkter Schranktüren oder mittels einer am Rahmengestell angelenkten Schranktür und einer lösbar am Rahmengestell angebrachten Rückwand verschließbar sind und dessen übrige Seiten mittels lösbar am Rahmengestell anbringbarer Abdeckplatten abdeckbar sind.

Ein derartiger Schaltschrank ist gegen elektromagnetische Strahlung nicht abgeschirmt, da die vorzugsweise oberflächenbehandelten Abdeckplatten, Rückwände und Schranktüren keine ausreichende elektrisch leitende Verbindung mit dem Rahmengestell haben. Dieser Übergang wird oft dadurch noch verschlechtert, daß die Abdeckplatten, Rückwände und Schranktüren nur über Befestigungsschrauben mit dem Rahmengestell verbunden sind und sich außerhalb dieser Befestigungsstellen mittels Dichtungsstreifen an dem Rahmengestell abstützen.

Wie die DE-OS 34 31 712 zeigt, können elektronische Geräte oder ein Gestell mit Einschüben dadurch HF-dicht abgeschirmt werden, daß man eine Haube aus Metall über die Geräte oder das Gestell stülpt, die Geräte oder das Gestell auf ein Bodenblech setzt und dann die Haube und das Bodenblech elektrisch leitend miteinander verbindet. Dabei kann zur Erleichterung des Zuganges zu den Geräten oder dem Gestell eine Wand der Haube mit einer Tür versehen werden, die in bekannter Weise mittels an sich bekannter Kontaktleisten mit der Haube verbunden wird.

Diese bekannte Abschirmhaube eignet sich nicht für Schaltschränke der eingangs erwähnten Art, die bereits selbst eine oder zwei Schranktüren besitzen. Eine Haube müßte dann zusätzlich eine oder zwei weitere HF-dicht abgeschirmte Türen erhalten, was die Abschirmung des Schaltschrankes erheblich verteuert. Eine geschlossene, vom Bodenblech abnehmbare Haube kann auch nicht befriedigen, da der Raum, in dem der Schaltschrank steht, oft nicht die erforderliche Höhe zum Abziehen der Haube besitzt. Bei einem Schaltschrank mit häufigem Zugang zu den eingebauten elektrischen Geräten und Einrichtungen ist eine derartige Lösung außerdem unbefriedigend.

Es ist Aufgabe der Erfindung, einen Schaltschrank der eingangs erwähnten Art auf einfache Art HF-dicht abzuschirmen, ohne den Zugang zum Innenraum des Schaltschrankes zu erschweren oder dafür einen erheblichen Mehraufwand an Türen vorsehen zu müssen.

Diese Aufgabe wird nach der Erfindung dadurch gelöst, daß zur HF-Abschirmung in das Rahmengestell ein zwei Seitenwände, eine Deckwand und eine Bodenwand aufweisender, kastenförmiger und HF-dichter Einsatz eingebracht und so mit dem Rahmengestell verbunden ist, daß die Vorder-und Rückseite des Rahmengestelles mit den Öffnungen des Einsatzes zusammenfallen, daß der Einsatz im Bereich beider Öffnungen auf allen Seiten seiner Innenwandung federnde Kontaktstreifen trägt, daß die Schranktüren und die Rückwand auf ihren Innenseiten mit Abschirmplatten versehen sind, die einen auf die Öffnungen des Einsatzes abgestimmten umlaufenden Rand aufweisen, und daß die Ränder der Abschirmplatten auf allen Außenseiten federnde Kontaktstreifen tragen, die in der Schließstellung von Schranktür und Rückwand mit den Kontaktstreifen des Einsatzes zur Deckung kommen und diesen HF-dicht mit den Abschirmplatten von Schranktür und Rückwand verbinden.

Der in das Rahmengestell eingesetzte Einsatz bringt schon eine HF-Abschirmung auf vier Seiten des Schaltschrankes, so daß nur noch die wahlweise, mit zwei Schranktüren oder mit einer Schranktür und einer Rückwand verschließbare Vorder-und Rückseite abgeschirmt weden müssen. Die in die Schranktür und die Rückwand eingebrachten Abschirmplatten werden über an sich bekannte Kontaktleisten mit dem Einsatz elektrisch leitend verbunden, der selbst an den zugeordneten Stellen mit Kontaktleisten versehen ist. Die Schranktür kann wie bei einem ungeschirmten Schaltschrank geöffnet und geschlossen werden. In der Schließstellung ist die Abschirmung wieder hergestellt. Der Einsatz und die Abschirmplatten sind im Schaltschrank untergebracht, so daß ihre Oberfläche elektrisch leitend bleiben kann. Die Kontaktgabe zu den Kontaktstreifen ist daher gewährleistet und die Spalte zwischen dem Einsatz und den beiden Abschirmplatten sind durchgehend elektrisch leitend überbrückt. In der Schließstellung des Schaltschrankes ist daher der gesamte Innenraum HF-dicht abgeschlossen. Dies gilt sowohl für einen Schaltschrank, bei dem die Vorder-und die Rückseite mit einer Schranktür verschließbar ist, als auch für einen Schaltschrank, bei dem die Vorderseite mit einer Schranktür verschließbar und die Rückseite mit einer Rückwand abdeckbar ist.

Schaltschränke dieser Art lassen sich auch ohne Seitenwände aneinanderreihen, ohne die HF-Abschirmung der einzelnen Schaltschränke zu beeinträchtigen. Die Einsätze können aus einem Blechzuschnitt abgekantet und zusammengeschweißt werden. Größere Einsätze werden bevorzugt aus einzelnen Platten zusammengesetzt. Dabei wird die Ausgestaltung so vorgenommen, daß die Seitenwände bildende Seitenplatten an ihren horizontalen Enden abgekantete Abschnitte aufweisen, die eine Deckplatte und eine Bodenplatte des Einsatzes teilweise überdecken und daß die Deckplatte und die Bodenplatte mit diesen Abschnitten der Seitenplatten großflächig verbunden sind.

Ist nach einer weiteren Ausgestaltung vorgesehen, daß der Einsatz mittels Leisten mit dem Rahmengestell verbunden ist, die zumindest mit den vertikalen Rahmenschenkeln des Rahmengestelles in Deckung sind und mit Befestigungsflanschen in den Innenraum des Einsatzes abstehen, dann können an diesen Leisten die Einschübe, Baugruppenträger und dgl. befestigt werden.

Die Anbringung der Kontaktstreifen an dem Einsatz und den Abschirmplatten ist nach einer Ausgestaltung so vorgenommen, daß die Kontaktstreifen im Querschnitt U-förmig ausgebildet sind, wobei die Endschenkel Klammeraufnahmen bilden, und daß die Kontaktstreifen mit einer Klammeraufnahme auf die die Öffnung umschließenden Kanten des Einsatzes und den Rand der Abschirmplatten aufgesteckt sind und sich mit dem anderen Endschenkel an dem Einsatz und dem Rand der Abschirmplatten abstützen.

Eine weitere Ausgestaltung sieht vor, daß der Rand der Abschirmplatten von Schranktür und Rückwand auf der Innenseite mittels aus Vierkantrohrabschnitten zusammengesetzten Rahmen versteift sind und daß diese Rahmen mit Reihen von Befestigungsaufnahmen versehen sind, um auch an den Schranktüren und der Rückwand Geräte und dgl. anbringen zu können, ohne die Abschirmung zu beeinträchtigen.

Die Abdichtung des Schaltschrankes im Bereich der Vorder-und Rückseite wird dabei dadurch vereinfacht, daß die Rahmenschenkel des Rahmengestelles im Bereich der Vorder-und Rückseite senkrecht dazu stehende Dichtungsstege aufweisen, die einen geschlossenen Rahmensteg bilden und daß bei geschlossenen Schranktüren und geschlossener Rückwand diese Dichtungsstege im Bereich der Öffnungen zusammen mit den Kanten des Einsatzes an gemeinsamen Dichtungsstreifen der Schranktür oder der Rückwand anliegen.

Die Erfindung wird anhand eines in den Zeichnungen dargestellten Ausführungsbeispiels näher erläutert. Es zeigt:

Fig. 1 in perspektivischer Ansicht das Rahmengestell eines Schaltschrankes mit dem einsetzbaren Einsatz zur HF-Abschirmung,

Fig. 2 eine perspektivische Teilansicht mit einer am Rahmengestell angelenkten Schranktür,

Fig. 3 einen Teilquerschnitt mit der angelenkten, geöffneten Schranktür und dem im Rahmengestell angeordneten Einsatz und

Fig. 4 einen der Fig. 3 entsprechenden Teilquerschnitt bei geschlossener und abgeschirmter Schranktür.

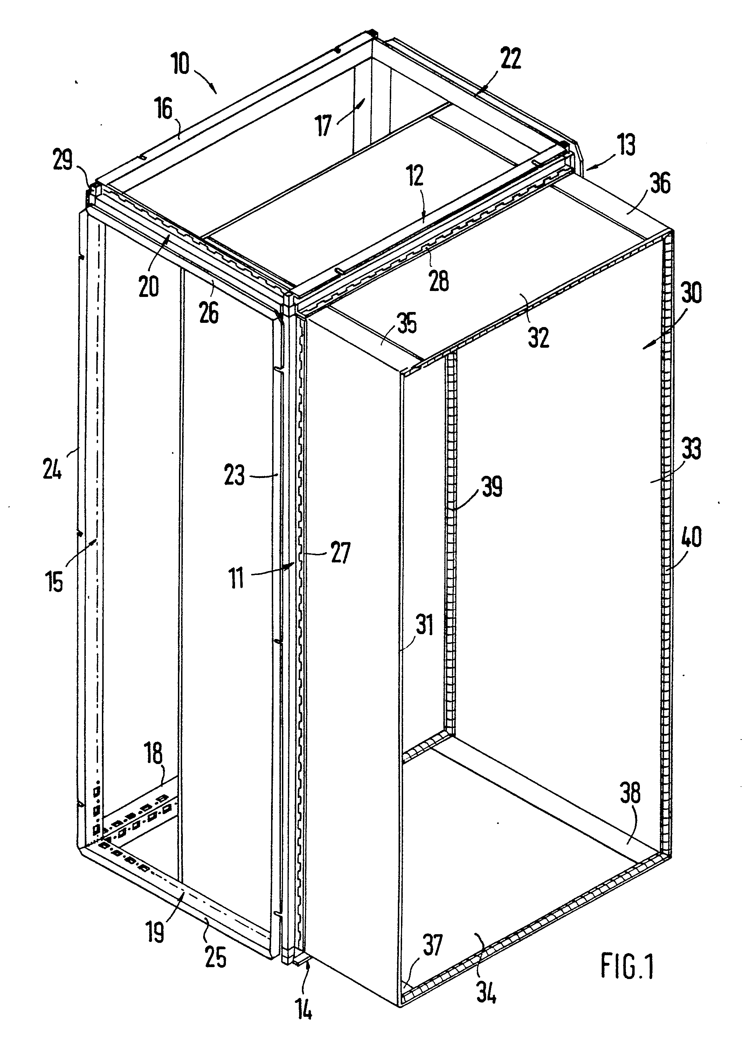

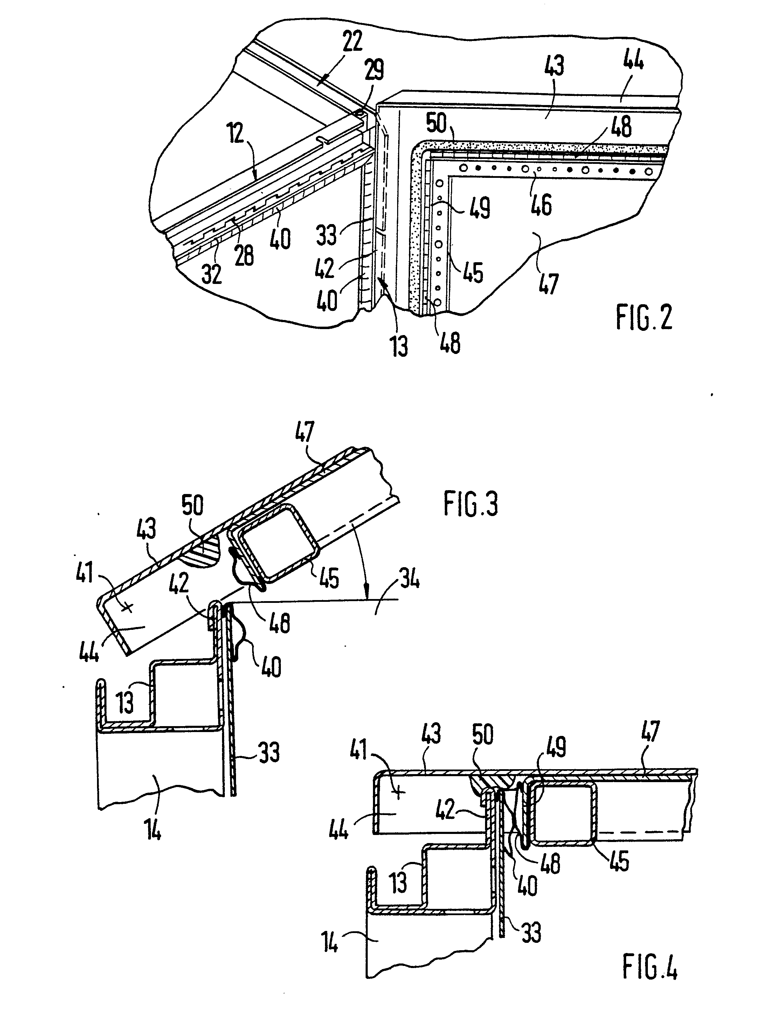

Der Schaltschrank weist das Rahmengestell 10 auf, das aus zwölf Rahmenschenkeln zusammengesetzt ist, von denen in Fig. 1 die Rahmenschenkel 11,12,13 und 14 der Vorderseite, die Rahmenschenkel 11,15,19 und 20 der linken Schrankseite, die Rahmenschenkel 15,16,17 und 18 der Rückseite und die Rahmenschenkel 13,17 und 22 der rechten Schrankseite einsehbar sind, da keine Abdeckplatten am Rahmengestell 10 angebracht sind. Die Rahmenschenkel sind Profilabschnitte, die in den Eckbereichen des Rahmengestelles 10 mittels Eckverbinder 29 miteinander verbunden sind.

Die linke und rechte Schrankseite des Rahmengestelles 10 und der Boden und die Decke werden mittels nicht dargestellter Abdeckplatten abgedeckt, die mit Flanschen der Rahmenschenkel verbunden werden. Diese Flansche bilden jeweils einen Befestigungsrahmen, an dem die Abdeckplatte befestigt wird, wie z.B. die Flansche 23,24,25 und 26 der linken Schrankseite zeigen. An der Vorderseite und Rückseite des Rahmengestelles 10 stehen die Dichtungsstege senkrecht ab, wie die Dichtungsstege 27,28 und 42 der Vorderseite zeigen. Diese Dichtungsstege bilden einen geschlossenen Rahmensteg.

Zur HF-Abschirmung wird in das Rahmengestell 10 der Einsatz 30 eingeschoben und darin befestigt. Dieser Einsatz 30 ist aus den beiden Seitenplatten 31 und 33, der Deckplatte 32 und der Bodenplatte 34 zusammengesetzt. Dabei sind die unteren und oberen Enden der Seitenplatten 31 und 33 senkrecht abgekantet. Diese abgekanteten Abschnitte 35,36,37 und 38 überdecken die Deckplatte 32 und die Bodenplatte 34 teilweise und sind in diesen Abschnitten großflächig mit diesen verbunden. Der kastenförmige Einsatz 30 ist damit an seinen vier Seiten HF-dicht und wird so in dem Rahmengestell 10 befestigt, daß seine Öffnungen mit der Vorder-und Rückseite des Rahmengestelles 10 zusammenfallen. Die Kanten des Einsatzes 30 im Bereich der Öffnungen schließen bündig mit dem Rahmensteg aus den Dichtungsstegen des Rahmengestelles an der Vorder-und der Rückseite des Schaltschrankes ab. Unmittelbar an diese Kanten des Einsatzes 30 sind auf den Innenwandungen desselben federnde Kontaktstreifen 39 und 40 umlaufend angebracht, die die Gegenkontakte für die an der Schranktür oder der Rückwand angebrachten federnden Kontaktstreifen bilden.

Wie die Fig. 2 bis 4 zeigen, ist die Schranktür 43 mit einem umlaufenden Rand 44 versehen und trägt auf der Innenseite die Abschirmplatte 47, die ebenfalls mit einem umlaufenden Rand 49 versehen ist. Dieser Rand 49 trägt auf seiner Außenseite umlaufend die federnden Kontaktstreifen 48. Bei geschlossener Schranktür 43 ragt der Rand 49 mit den Kontaktstreifen 48 in die Öffnung des Einsatzes 30, so daß diese mit den Kontaktstreifen 40 desselben zur Deckung kommen und rings um den Rand 49 eine elektrisch leitende Verbindung mit dem Einsatz 30 herstellen.

Fig. 2 läßt erkennen, daß die Dichtungsstege 28 und 42 der Rahmenschenkel 12 und 13 bündig mit den Kanten der Deckplatte 32 und der Seitenplatte 33 abschließen, wenn der Einsatz 30 im Rahmengestell 10 befestigt ist. Dazu werden vorzugsweise nicht dargestellte Leisten verwendet, die mit den Rahmenschenkeln des Rahmengestelles 10 fluchten und mit diesen verbunden. z.B. verschraubt, sind. Diese Leisten stehen mit einem Befestigungsflansch in den Innenraum des Einsatzes 30, so daß daran Geräte, Baugruppenträger und dgl. befestigt werden können.

Die Schranktür 43 ist an dem Rahmenschenkel 13 angelenkt, wie mit dem Bezugszeichen 41 angedeutet ist. Dazu können Scharniere verwendet sein, die mit dem einen Scharnierteil am Rand 44 der Schranktür 43 und mit dem anderen Scharnierteil an dem Rahmenschenkel 13 befestigt sind.

Auf der Innenseite des Randes 49 der Abschirmungsplatte 47 ist ein aus Vierkantrohrabschnitten 45 zusammengesetzter Rahmen befestigt, der nicht nur die Schranktür versteift, sondern auch mit Befestigungsaufnahmen versehen ist, so daß auf der Innenseite der mit der Abschirmplatte 47 versehenen Schranktür 43 ebenfalls Geräte und dgl. befestigt werden können.

Ist die Schranktür 43 geschlossen, dann bilden die elastischen Kontaktstreifen 40 und 48 einen umlaufenden Kontakt, der die Spalte zwischen der Öffnung des Einsatzes 30 und dem Rand 49 der Abschirmplatte 47 schließen. Dabei werden die Kontaktstreifen 40 und 48 verformt, so daß sie unter Spannung aufeinanderliegen. Die Kontaktstreifen 40 und 48 sind U-förmig und die Endschenkel bilden Klammeraufnahmen, so daß sie auf die Endkante des Einsatzes 30 bzw. des Randes 49 der Abschirmplatte 47 aufgesteckt werden können. Die jeweils anderen Endschenkel stützen sich an der Innenwandung des Einsatzes 30 bzw. an der Außenseite des Randes 49 der Abschirmplatte 47 ab, wie der Fig. 4 zu entnehmen ist.

Um den Rand 49 der Abschirmplatte 47 trägt die Innenseite der Schranktür 43 den umlaufenden Dichtungsstreifen 50, der bei geschlossener Schranktür 43 gegen die Dichtungsstege des Rahmengestelles 10 und die Kanten des Einsatzes 30 abdichtet, wie Fig. 4 zeigt.

Die Rückseite des Schaltschrankes kann in gleicher Weise mit einer Schranktür verschließbar sein. Dabei kann die Schranktür am Rahmenschenkel 15 oder am Rahmenschenkel 17 angelenkt sein. Die Rückseite kann aber auch mittels einer Rückwand HF-dicht abgedeckt sein. Die Rückwand ist genau so aufgebaut wie die Schranktür 43 mit der Abschirmplatte 47. Die Rückwand wird jedoch mit den Rahmenschenkeln 15,16,17 und 18 verschraubt, wobei die Kontaktstreifen 48 mit den Kontaktstreifen 39 des Einsatzes die elektrisch leitende Verbindung zwischen der Abschirmplatte der Rückwand und dem Einsatz 30 herstellen.

## Ansprüche

1. Schaltschrank mit einem Rahmengestell, dessen Vorder-und Rückseite mittels zweier am Rahmengestell angelenkter Schranktüren oder mittels einer am Rahmengestell angelenkten Schranktür und einer lösbar am Rahmengestell angebrachten Rückwand verschließbar sind und dessen übrige Seiten mittels lösbar am Rahmengestell anbringbarer Abdeckplatten abdeckbar sind, dadurch gekennzeichnet, daß zur HF-Abschirmung in das Rahmengestell (10) ein zwei Seitenwände, eine Deckwand und eine Bodenwand aufweisender, kastenförmiger und HF-dichter Einsatz (30) eingebracht und so mit dem Rahmengestell (10) verbunden .ist, daß die Vorder-und Rückseite des Rahmengestelles (10) mit den Öffnungen des Einsatzes (30) zusammenfallen, daß der Einsatz (30) im Bereich beider Öffnungen auf allen Seiten seiner Innenwandung federnde Kontaktstreifen (39,40) trägt, daß die Schranktüren (43) und die Rückwand auf ihren Innenseiten mit Abschirmplatten (47) versehen sind, die einen auf die Öffnungen des Einsatzes (30) abgestimmten umlaufenden Rand (49) aufweisen, und daß die Ränder (49) der Abschirmplatten (47) auf allen Außenseiten federnde Kontaktstreifen (48) tragen, die in der Schließstellung von Schranktür (43) und Rückwand mit den Kontaktstreifen (39,40) des Einsatzes (30) zur Deckung kommen und diesen HF-dicht mit den Abschirmplatten (47) von Schranktür (43) und Rückwand verbinden.

2. Schaltschrank nach Anspruch 1, dadurch gekennzeichnet, daß die Seitenwände bildende Seitenplatten (31, 33) an ihren horizontalen Enden abgekantete Abschnitte (35,36,37,38) aufweisen, die eine Deckplatte (32) und eine Bodenplatte (34) des Einsatzes (30) teilweise überdecken und daß die Deckplatte (32) und die Bodenplatte (34) mit diesen Abschnitten (35,36,37,38) der Seitenplatten (31,33) großflächig verbunden sind.

3. Schaltschrank nach Anspruch 1 oder 2, dadurch gekennzeichnet, daß der Einsatz (30) mittels Leisten mit dem Rahmengestell (10) verbunden ist, die zumindest mit den vertikalen Rahmenschenkeln (11,13,15,17) des Rahmengestelles (10) in Deckung sind und mit Befestigungsflanschen in den Innenraum des Einsatzes (30) abstehen.

4. Schaltschrank nach einem der Ansprüche 1 bis 3, dadurch gekennzeichnet, daß die Kontaktstreifen (39,40,48) im Querschnitt U-förmig ausgebildet sind, wobei die Endschenkel Klammeraufnahmen bilden, und daß die Kontaktstreifen (39,40,48) mit einer Klammeraufnahme auf die die Öffnung umschließenden Kanten des Einsatzes (30) und den Rand (49) der Abschirmplatten (47) aufgesteckt sind und sich mit dem anderen Endschenkel an dem Einsatz (30) und dem Rand (49) der ·Abschirmplatten (47) abstützen.

5. Schaltschrank nach einem der Ansprüche 1 bis 4, dadurch gekennzeichnet, daß der Rand (49) der Abschirmplatten (47) von Schranktür (43) und Rückwand auf der Innenseite mittels aus Vierkantrohrabschnitten (45) zusammengesetzten Rahmen versteift sind und daß diese Rahmen mit Reihen von Befestigungsaufnahmen versehen sind.

6. Schaltschrank nach einem der Ansprüche 1 bis 5, dadurch gekennzeichnet, daß die Rahmenschenkel (11,12,13,14 bzw. 15,16,17,18) des Rahmengestelles (10) im Bereich der Vorder-und Rückseite senkrecht dazu stehende Dichtungsstege (27,28,42) aufweisen, die einen geschlossenen Rahmensteg bilden, und daß bei geschlossenen Schranktüren (43) und geschlossener Rückwand diese Dichtungsstege (27,28,42) im Bereich der Öffnungen zusammen mit den Kanten des Einsatzes (30) an gemeinsamen Dichtungsstreifen (50) der Schranktür (43) oder der Rückwand anliegen.

FIG.1

A 6260

0 240 885

FIG.2

FIG.3

FIG.4

6260